# EUROPÄISCHE PATENTSCHRIFT

(11) **EP 1 678 746 B1**
(45) Veröffentlichungstag und Bekanntmachung des Hinweises auf die Patenterteilung: **30.11.2011**
(21) Anmeldenummer: 04804501.7
(22) Anmeldetag: 20.10.2004
(51) Int. Cl.: H01L 21/02, H01L 21/318, H01L 23/522, C23C 16/34, C23C 16/455, C23C 16/511, H01L 21/768

(54) **Verfahren zum Ausbilden eines Dielektrikums auf einer kupferhaltigen Metallisierung**
Method for forming a dielectric on a copper-containing metallisation
Procédé de formation d'un diélectrique sur une couche de metallisation contenant du cuivre

(30) Priorität: 30.10.2003 DE 10350752
(43) Veröffentlichungstag der Anmeldung: 12.07.2006
(73) Patentinhaber: Infineon Technologies AG, 85579 Neubiberg (DE)
(72) Erfinder: GSCHWANDTNER, Alexander, 80687 München (DE); HOLZ, Jürgen, 01127 Dresden (DE); SCHRENK, Michael, 86911 Diessen am Ammersee (DE)
(74) Vertreter: Karl, Frank
(86) Internationale Anmeldenummer: PCT/EP2004/052594
(87) Internationale Veröffentlichungsnummer: WO 2005/043623

(56) Entgegenhaltungen:
- EP-A- 1 130 654
- US-A- 5 946 567
- US-A1- 2003 011 043
- US-A1- 2003 013 320
- US-A1- 2003 024 477
- US-A1- 2003 040 199
- LUCOVSKY G ET AL.: "Formation of thin film dielectrics by remote plasma-enhanced chemical-vapor deposition (Remote PECVD)" APPLIED SURFACE SCIENCE, NORTH-HOLLAND, Bd. 39, 1989, Seiten 33-56, XP002327337 AMSTERDAM ISSN: 0169-4332
- TSU D V ET AL: "SILICON NITRIDE AND SILICON DIIMIDE GROWN BY REMOTE PLASMA ENHANCED CHEMICAL VAPOR DEPOSITION" JOURNAL OF VACUUM SCIENCE AND TECHNOLOGY: PART A, AMERICAN INSTITUTE OF PHYSICS. NEW YORK, US, Bd. 4, Nr. 3, PART 1, Mai 1986 (1986-05), Seiten 480-485, XP000810501 ISSN: 0734-2101
- RICHARD P D ET AL: "REMOTE PLASMA ENHANCED CVD DEPOSITION OF SILICON NITRIDE AND OXIDE FOR GATE INSULATORS IN (IN,GA)AS FET DEVICES" JOURNAL OF VACUUM SCIENCE AND TECHNOLOGY: PART A, AMERICAN INSTITUTE OF PHYSICS. NEW YORK, US, Bd. 3, Nr. 3, PART 1, Mai 1985 (1985-05), Seiten 867-872, XP000809721 ISSN: 0734-2101

## Beschreibung

Die Erfindung betrifft ein Verfahren zum Ausbilden eines Dielektrikums auf einer kupferhaltigen Metallisierung, mit den Schritten:
- Erzeugen einer Metallisierung auf einem Substrat, wobei die Metallisierung als einen Metallisierungsbestandteil Kupfer enthält, insbesondere aus Kupfer besteht,
- Heranführen mindestens zweier Prozessgase,
- Ausbilden eines Dielektrikum mit mindestens zwei Arten von Bestandteilen, die aus voneinander verschiedenen Prozessgasen stammen.

Die vorrangigen elektrischen Eigenschaften eines Dielektrikums sind u.a.:
- der Leckstrom bzw. der Kriechstrom,
- die Durchbruchspannung,
- die Zuverlässigkeit.

Aus der europäischen Offenlegungsschrift EP 1 130 654 A1 ist eine Kondensatoranordnung bekannt, bei der eine zusätzliche Maßnahme darin besteht, eine metallisch leitende Barriereschicht auf einer Kupfermetallisierung aufzubringen, bevor das Dielektrikum erzeugt wird. Mit dem Aufbringen und Strukturieren der metallisch leitenden Barriereschicht sind zusätzliche Verfahrensschritte verbunden. Außerdem leitet die Barriereschicht weniger gut als die Metallisierung, so dass die elektrischen Eigenschaften des Kondensators herabgesetzt werden. Im Übrigen erfüllen leitende Barriereschichten ihre Barrierefunktion nicht immer vollständig.

Aus Lucovsky, G. u. a., "Formation of thin film dielectrics by remote plasma-enhanced chemical vapor deposition (Remote PECVD), Applied Surface Devices, North Holland, Bd. 39, 1989, Seiten 33 bis 56; Tsu, D. V. and Lucovsky, G., "Silicon nitride and silicon diimide grown by remote plasma enhanced chemical vapor deposition", J. Vac. Sci. Technol., A, Bd. 4, Nr. 3, May/Jun 1986, Seiten 480 bis 485; sowie aus Richard, P. D., Markunas, R. J., Lucovsky, G. u. a., "Remote plasma enhanced CVD deposition of silicon nitride and oxide for gate insulators in (In,Ga)As FET devices", J. Vac. Sci. Technol. A3 (3), May/Jun 1985, S.867 - 872, sind Remoteplasma CVD Verfahren bekannt.

Die US 2003/0013320 A1 und US 2003/0024477 A1 betreffen Batchprozesse, die ggf. auch mit Remoteplasma ausgeführt werden können. Aus der US 2003/0040199 A1 ist ein lichtunterstützter Plasma-CVD-Apparat bekannt. Aus der US 2003/0011043A1 und der US 5,946,567 sind Verfahren zum Herstellen von MIM-Kondensatoren bekannt.

Es ist Aufgabe der Erfindung ein einfaches Verfahren zum Ausbilden eines Kondensatordielektrikums auf einer Kupfer enthaltenden Metallisierung anzugeben.

Die auf das Verfahren bezogene Aufgabe wird durch die im Patentanspruch 1 angegebenen Verfahrensschritte gelöst. Weiterbildungen sind in den Unteransprüchen angegeben.

Zusätzlich zu den eingangs genannten Verfahrensschritten werden bei dem erfindungsgemäßen Verfahren die folgenden Verfahrensschritte ausgeführt:
Ausbilden des Dielektrikums angrenzend an die Metallisierung, wobei die beiden Prozessgase mit voneinander verschiedener Plasmaleistung je Substratfläche angeregt werden oder wobei das eine Prozessgas mit einem Plasma angeregt wird und das andere Prozessgas nicht angeregt wird.

Durch diese Verfahren wird die frühzeitige Zersetzung des nicht oder nur schwach angeregten Prozessgases verhindert. Diese Zersetzung würde die Bildung eines hochwertigen Dielektrikums auf Kupfer verhindern oder erheblich stören. Andererseits ist die starke Anregung des anderen Prozessgases ebenfalls eine Voraussetzung für die Bildung eines hochqualitativen Dielektrikums auf Kupfer.

Bei einer Ausgestaltung werden die folgenden Schritte ausgeführt:
- Verwenden mindestens eines problematischen bzw. kritischen Prozessgases das selbst oder ein Bestandteil dessen mit mindestens einem Metallisierungsbestandteil ohne zusätzliche Maßnahmen bzw. bei Überschreitung einer Grenzplasmaleistung je freiliegender Substratfläche eine Nebenphase bilden würde, welche die elektrischen Eigenschaften eines Dielektrikums erheblich beeinträchtigen würde. Die Grenzplasmaleistung wird bezüglich des problematischen Prozessgases nicht überschritten und bleibt bspw. unter 0,1 W/cm² oder 0,5 W/cm² Substratfläche, wobei auf die von außen angelegte Leistung bezug genommen wird.

Bei einer Ausgestaltung werden die folgenden Schritte durchgeführt:
- Ausbilden des Dielektrikums angrenzend an die Metallisierung, wobei das Dielektrikum mindestens eine Art problematischer Bestandteile enthält, die aus einem problematischen Prozessgas stammen, und wobei das Dielektrikum mindestens eine Art unproblematischer Bestandteile enthält, die aus mindestens einem unproblematischen Prozessgas des Prozessgasgemisches stammen,
- wobei , das Verhältnis des problematischen Prozessgases zu dem unproblematischen Prozessgas so eingestellt wird, dass das Verhältnis der Anzahl der problematischen Verbindungs-Bestandteile im Prozessgasgemisch und der Anzahl der unproblematischen Verbindungs-Bestandteile im Prozessgasgemisch kleiner als 10 Prozent oder kleiner als 0,1 Prozent des Verhältnisses der Anzahl der problematischen Verbindungs-Bestandteile im Dielektrikum und der unproblematischen Verbindungs-Bestandteile im Dielektrikum ist. Ein Verbindungsbestandteil ist bspw. Silizium. Der andere Verbindungsbestandteil ist bspw. Stickstoff.

Bei dieser Ausgestaltung des erfindungsgemäßen Verfahrens ist der Anteil der problematischen Bestandteile im Prozessgasgemisch insbesondere unterstöchiometrisch im Vergleich zum Anteil der problematischen Bestandteile im Dielektrikum, so dass auf Grund der Unterstöchiometrie bereits die Bildung der störenden Nebenphase reduziert ist.

Die untere Grenze für den Anteil der problematischen Bestandteile wird durch die benötigten Wachstumsraten festgelegt. Vorzugsweise sind die genannten Prozentzahlen größer als 0,01 Prozent oder größer als 0,001 Prozent.

Enthält das Dielektrikum mehrere problematische Bestandteile, so muss die genannte Bedingung für jeden problematischen Bestandteil eingehalten werden, um die Bildung der Nebenphase zu verhindern.

Bei einer Weiterbildung wird das Dielektrikum mit Hilfe eines Abscheideverfahrens erzeugt, bei dem die Prozessgase voneinander getrennt herangeführt werden, wobei mit dem Heranführen von unproblematischem Prozessgas begonnen wird. Die Weiterbildung beruht auf der Überlegung, dass das unproblematische Prozessgas auf der Metallisierung eine dünne Schutzschicht bildet, die die Bildung von störenden Nebenphasen beeinträchtigt oder verhindert. Bei dem Verfahren bildet sich in jedem Zyklus nur eine Atomlage oder nur wenige Atomlagen, weshalb das Verfahren auch als Atomlagen-Abscheidung (Atomic Layer Deposition - ALD) bezeichnet wird. In weiteren Zyklen wird die Schutzwirkung im Vergleich zum ersten Zyklus immer mehr verstärkt, so dass bei einer Ausgestaltung auch wieder andere Abscheideverfahren verwendet werden.

Bei der Weiterbildung ist die getrennte Heranführung der Prozessgase auch deshalb besonders wichtig, damit keine Reaktionsprodukte unkontrolliert Ausflocken und zu inhomogenen Atomlagen führen.

Bei beiden Alternativen wird die Metallisierung unmittelbar vor dem Erzeugen des Dielektrikums in einem Reinigungsschritt gereinigt, bspw. durch Rücksputtern oder durch einen nasschemischen Reinigungsschritt.

Bei der Erfindung wird das Dielektrikum ohne zwischen dem Dielektrikum und der unteren Elektrode angeordnete zusätzliche Barriereschicht aufgebracht. Dies ermöglicht neue Integrationskonzepte, die erheblich einfacher als bisherige Konzepte sind und die unten an Hand der Ausführungsbeispiele näher erläutert werden, insbesondere ein sogenanntes POWER-LIN-Konzept bei dem lineare Kondensatoren ohne zusätzlichen fotolithografischen Schritt zwischen Betriebsspannungsleitungen aus Kupfer in Kupfermetallisierungslagen angeordnet werden.

Auch ein sogenanntes PAD-LIN-CAP-Konzept wird möglich, bei dem Kondensatoren ohne zusätzlichen fotolithografischen Schritt zwischen der letzten Kupfer-Metallisierungslage und einer darüber liegenden Aluminiumlage ausgebildet werden, wobei die Aluminiumlage zum Bonden dient.

Bei einer Weiterbildung wird das Dielektrikum, d.h. ein elektrisch nicht leitfähiges Material, aus einem Material ausgebildet, das eine Diffusionsbarriere für Kupfer ist und dass der Elektromigration von Kupfer entgegenwirkt. Zusätzliche Schichten zum Erbringen dieser Wirkungen werden nicht abgeschieden, insbesondere keine elektrisch leitfähigen Barriereschichten. Siliziumnitrid ist ein besonders geeignetes Material, da es einfach hergestellt werden kann und sich gut mit den anderen gebräuchlichen Materialien für Halbleiterschaltungen verträgt. Zur Herstellung von Siliziumnitrid wird ein siliziumhaltiges Prozessgas verwendet, das auf Grund des Siliziumanteils problematisch ist. So könnte sich ohne die zusätzliche Maßnahme verstärkt ein Silizid als störende Nebenphase bilden, insbesondere Kupfersilizid. Geeignete siliziumhaltige Prozessgase sind Silan, Disilan, Dichlorsilan, Trichlorsilan, Bis(tertbutylamino)silan bzw. BTBAS oder einem Gasgemisch als mindestens zwei dieser Gase.

Bei einer Weiterbildung beträgt der Metallisierungsanteil des Kupfers mindestens neunzig Volumenprozent der Metallisierung. Eine direkte Abscheidung eines Dielektrikums auf Kupfer ist erst durch die erfindungsgemäßen Verfahren auf einfache Weise möglich.

Die Erfindung betrifft bei einer Ausgestaltung Verfahren zum Ausbilden eines Dielektrikums auf einer Metallisierung, bei dem die Prozessgase, aus denen die Bestandteile des Dielektrikums stammen, so ausgewählt worden sind, dass weder diese Prozessgase noch deren Bestandteile mit dem Kupfer einer Metallisierung eine Nebenphase bilden, welche die elektrischen Eigenschaften des Dielektrikums erheblich beeinträchtigen würde. Die Ausgestaltung geht von der Überlegung aus, das die Bildung von störenden Nebenphasen auch durch eine geeignete Wahl des Materials des Dielektrikums und der Prozessgase verhindert werden kann. Auch bei dem Verfahren gemäß der Ausgestaltung wird das Dielektrikum ohne zwischen dem Dielektrikum und der unteren Elektrode angeordnet zusätzliche Barriereschicht aufgebracht. Dies ermöglicht ebenfalls die oben angesprochenen neuen Integrationskonzepte. Aber auch hochqualitative Dielektrika für andere Einsatzzwecke als in Kondensatoren werden mit dem erfindungsgemäßen Verfahren hergestellt.

Bei einer Weiterbildung des Verfahrens wird ein Dielektrikum aus Aluminiumnitrid erzeugt. Als Prozessgase werden insbesondere Trimethylaluminium und ein stickstoffhaltiges Gas verwendet. Damit sind weder im Dielektrikum noch im Prozessgas problematische Bestandteile wie Sauerstoff oder Silizium enthalten, die zur Bildung von störenden Nebenphasen führen. Insbesondere kann sich kein Kupfersilizid und kein Kupferoxid bilden.

Bei einer anderem Weiterbildung mit der genannten Materialauswahl wird das Dielektrikum mit Hilfe eines Abscheideverfahrens erzeugt, bei dem die Prozessgase mit Bestandteilen zur Bildung des Dielektrikums voneinander getrennt herangeführt werden, vorzugsweise zyklisch, insbesondere in mindestens fünf oder mindestens zehn Zyklen. Dieses Verfahren wird als Atomlagenabscheidung bezeichnet und führt zu Dielelektrikumschichten mit besonders gleichmäßiger Schichtdicke, insbesondere im Vergleich zu anderen Abschiedverfahren. Bspw. lässt sich Aluminiumnitrid mit der Atomlagenabscheidung in hinreichend gleichmäßiger Schichtdicke abscheiden. Die Dicke des Dielektrikums bzw. des Dielektrikumstapels liegt vorzugsweise im Bereich von drei Nanometern bis fünfzig Nanometern.

Bei einer Weiterbildung wird ein Prozessgas mit einem Bestandteil, der auch im Dielektrikum enthalten ist, im Vergleich zu mindestens einem anderen Prozessgas, insbesondere im Vergleich zu einem Prozessgas mit einem Bestandteil, der auch im Dielektrikum enthalten ist, weniger stark angeregt. Insbesondere wird das problematische Prozessgas weniger stark angeregt. Dadurch wird erreicht, dass die Bildung der Nebenphasen nicht nur durch die verringerte Konzentration der problematischen Bestandteile sondern auch durch deren verringerten Anregungszustand besonders wirksam verhindert wird. Die zusätzliche Anregung des unproblematischen Gases führt andererseits dazu, dass die problematischen Bestandteile vorrangig mit den angeregten Bestanteilen unter Bildung des Dielektrikums reagieren.

Bei einem Atomlagenabscheidungsverfahren führt die Aktivierung des einen Prozessgases zu verstärkten Wechselwirkungen mit der Oberfläche der Metallisierung, insbesondere zu einer gleichmäßigen Anlagerung von Bestandteilen, die dann beim Einlassen des anderen Prozessgases das Dielektrikum bilden.

Außerdem würde sowohl bei einer CVD Abscheidung (Chemical Vapor Deposition) als auch bei einer Atomlagenabscheidung eine zu starke Anregung von bestimmten Prozessgasen, bspw. von siliziumhaltigen Gasen, zu der frühzeitigen Zersetzung und damit verbunden auch zu einer unerwünschten Abscheidung führen, bspw. von amorphem bzw. polykristallinem Silizium in der Anregungskammer, bspw. in einer Vorkammer.

Bei der Erfindung wird das stärker angeregte Prozessgas getrennt von dem weniger stark oder nicht angeregten Prozessgas angeregt in einer von einer Reaktionskammer getrennten Kammer. Verfahren mit getrennter Anregungskammer werden auch als Remote-Plasma-Verfahren bezeichnet. Jedoch wird bei der Atomlagenabscheidung auch die Reaktionskammer zur Anregung verwendet, da sich die Prozessgase zu verschiedenen Zeiten in der Reaktionskammer befinden. Zur Anregung ist insbesondere ein Plasma geeignet, das bspw. durch induktive Einkopplung, durch kapazitive Einkopplung oder auf andere Art erzeugt wird.

Bei der Erfindung ist das Dielektrikum das Dielektrikum eines Kondensators, insbesondere eines Kondensators mit zwei metallischen Elektroden, zwischen denen das Dielektrikum angeordnet ist. Bei einer nächsten Weiterbildung wird das gesamte Dielektrikum des Kondensators mit einem erfindungsgemäßen Verfahren oder einer seiner Weiterbildungen und damit mit einer kleinen Anzahl von verschiedenen Verfahrensschritten hergestellt.

Bei einer alternativen Weiterbildung wird das Dielektrikum als Schichtstapel hergestellt. So wird nach einem erfindungsgemäßen Verfahren mindestens eine weitere dielektrischen Schicht angrenzend an die Dielektrikumschicht erzeugt, wobei die weitere Schicht eine andere Materialzusammensetzung hat und/oder mit einem anderen Verfahren und/oder mit anderen Prozessparametern erzeugt wird als die Dielektrikumschicht. Nachdem die Bildung von Nebenphasen anfangs verhindert worden ist, wirkt das bereits aufgebrachte Dielektrikum als Schutzschicht. Materialien mit einer größeren relativen Dielektrizitätskonstante als das zuerst aufgebrachte Dielektrikum lassen sich unproblematisch aufbringen, z.B. Aluminiumoxid, insbesondere Aluminiumtrioxid Al₂O₃, Aluminiumoxynitrid, Tantaloxid, insbesondere Tantalpentoxid Ta₂O₅, Tantaloxynitrid, Hafniumoxid, Bariumstrontiumtitanat o.ä. Aluminiumoxide lassen sich besonders einfach ausgehend von einer Aluminiumnitridschicht bilden. Insbesondere kommen aber auch die Materialien Aluminiumnitrid und Siliziumnitrid zum Einsatz, sowohl bei einer Grundschicht aus Aluminiumnitrid aber auch bei einer Grundschicht aus Siliziumnitrid.

Im ersten Abscheidungsschritt wird bspw. eine Abscheidebedingung gewählt, welche insbesondere keine Nebenphasen erzeugt und ein gute Barriereschicht ergibt, z.B. mit einer Dicke von 5 bis 10 nm. Anschließend wird in einem zweiten Abscheideschritt die Abscheidung auf beste Dielektrikumseigenschaften optimiert, bspw. auf ein stöchiometrisches Verhältnis der Verbindungsbestandteile im Dielektrikum.

Überraschender Weise wurde bei einer Weiterbildung festgestellt, dass sich die elektrischen Eigenschaften des Dielektrikums des Kondensators weiter verbessern, wenn auch ein obere Schicht des Dielektrikumstapel mit einem erfindungsgemäßen Verfahren oder einer seiner Weiterbildungen ausgebildet wird.

Im Folgenden werden Ausführungsbeispiele der Erfindung an Hand der beiliegenden Zeichnungen erläutert. Darin zeigen:
- Figur 1: eine Anlage zum Durchführen eines RPE-CVD Si₃N₄ Verfahrens,
- Figur 2: Verfahrensschritte bei der Durchführung eines RPE-ALCVD Si₃N₄ Verfahrens bzw. eines RPE-ALCVD AlN Verfahrens,
- Figur 3: eine Kondensatoranordnung, die mit zwei zusätzlichen Maskenschritten erzeugt worden ist,
- Figur 4: eine Kondensatoranordnung, die mit einem zusätzlichen Maskenschritten erzeugt worden ist, und
- Figur 5: eine Kondensatoranordnung, die keinen zusätzlichen Maskenschritten benötigt.

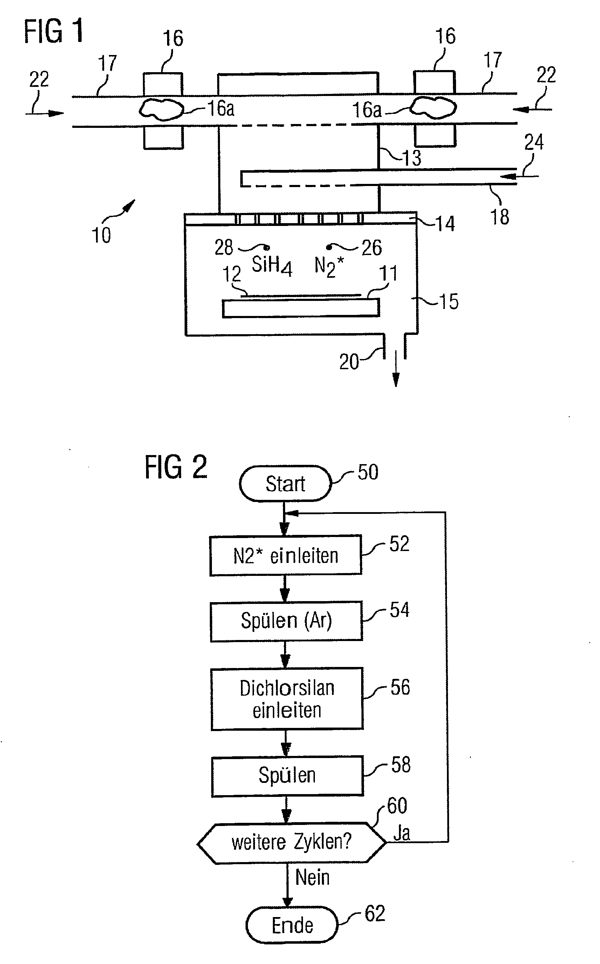

Figur 1 zeigt einen Prozessreaktor 10 mit dessen Hilfe sich u.a. ein RPE-CVD (Remote Plasma Enhanced Chemical Vapor Deposition) Si₃N₄ Verfahren durchführen lässt. Jedoch lassen sich mit dem Prozessreaktor 10 auch die unten an Hand der Figur 2 erläuterten Atomic-Layer-Verfahren durchführen.

Der Prozessreaktor 10 enthält eine Prozesskammer 15, in der auf einer Substrat-Elektrode 11 ein zu beschichtendes Substrat 12 angeordnet ist, bspw. ein Halbleiterwafer. Oberhalb der zu beschichtenden Oberseite des zu beschichtenden Substrates 12 ist an der Decke der Prozesskammer 15 eine Einlass-Elektrode 14 angeordnet, die eine Vielzahl von kleinen Durchtrittsöffnungen für die Prozessgase hat.

Zwischen den Elektroden 11 und 14 wird eine Hochfrequenzspannung angelegt, wenn ein Plasma in der Prozesskammer erzeugt werden soll, bspw. im Verlauf der unten an Hand der Figuren zwei erläuterten Verfahren.

Ist dagegen eine separate Zersetzung und Anregung von Prozessgasen erforderlich, so lassen sich die Prozessgase über Zuleitungen 17 getrennt zuführen. Jeder Zuleitung 17 ist eine Energiequelle 16 zugeordnet, bspw. ein Mikrowellensender, mit deren Hilfe in der betreffenden Zuleitung ein Plasma 16a gezündet werden kann. Die Zuleitungen 17 münden in einer Vorkammer 13, die über die Durchtrittsöffnungen in der Einlass-Elektrode 14 mit der Prozesskammer 15 verbunden ist.

Soll nur ein Prozessgas angeregt werden, so ist eine Zuleitung 17 und eine Energiequelle ausreichend. Die Zuleitungen werden bspw. aus Keramikmaterial hergestellt.

Außer Prozessgasen werden bei anderen Ausführungsbeispielen auch inerte Gase in den Zuleitungen 17 angeregt, bspw. Argon oder Helium. Zum Heranführen von nicht zur Anregung vorgesehenen Prozessgasen wird eine Zuführung 18 verwendet, die ebenfalls in die Vorkammer 13 mündet. Reaktionsprodukte und nicht verbrauchte Prozessgase werden mit Hilfe einer Pumpe 20 aus der Prozesskammer 15 abgesaugt.

Bspw. werden die Folgenden Betriebsparameter verwendet:
- Mikrowellenleistung einer Energiequelle 16 zwischen 700 und 850 Watt,
- Druck in der Prozesskammer 15 zwischen 5 Pa und 100 Pa,
- Hochfrequenzleistung zwischen 0,02 bis 0,1 W/cm²,
- stickstoffhaltiger Gasfluss 200 bis 400 sccm/min,
- Silanfluss 10 bis 30 sccm/min.

Zur Abscheidung von Siliziumnitrid nach dem erfindungsgemäßen Verfahren wird bspw. Stickstoff durch die Zuleitungen 17 eingelassen und mit Hilfe der Remote-Plasma 16a angeregt, siehe Pfeile 22. Silan SiH₄ wird durch die Zuleitung 18 ohne Anregung eingeleitet, siehe Pfeil 24. Angeregte Stickstoffradikale 26 und Silanmoleküle 28 reagieren auf der heißen Oberfläche des Substrates 12 zu Siliziumnitrid bei Temperaturen zwischen 200 °C und 500 °C. In der Prozesskammer 15 wird bei dem Ausführungsbeispiel kein Plasma gezündet. Bei einer Ausgestaltung wird in der Prozesskammer 15 ein leistungsschwaches Plasma mit der genannten Hochfrequenzleistung gezündet, so dass auch das Silan schwach angeregt wird.

Das Verhältnis zwischen Silan und Stickstoff, wird so eingestellt, wie in der Beschreibungseinleitung angegeben, um die Bildung von Kupfersilizid zu vermeiden.

Figur 2 zeigt Verfahrensschritte bei der Durchführung eines RPE-ALCVD (Remote Plasma Enhanced Atomic Layer Chemical Vapor Deposition) Si₃N₄ Verfahrens bzw. eines RPE-ALCVD AlN Verfahrens. Zur Durchführung der Verfahren wird bspw. der Prozessreaktor 10 verwendet.

Zunächst wird das RPE-ALCVD Si₃N₄ Verfahren erläutert. Das Verfahren beginnt in einem Verfahrensschritt 50 mit einem Vorreinigungsschritt, z.B. einem Rücksputterschritt. In einem dem Verfahrensschritt 50 nachfolgenden Verfahrensschritt 52 wird anschließend über die Zuleitungen 17 angeregtes Stickstoffgas in die Prozesskammer eingleitet, wobei in der Prozesskammer 15 kein weiteres Prozessgas enthalten ist, insbesondere kein siliziumhaltiges Prozessgas.
Danach wird in einem folgende Verfahrensschritt 54 die Prozesskammer 15 mit einem inerten Gas gespült, bspw. mit Argon. Das Argon wird bspw. durch eine nicht dargestellte Zuleitung in die Prozesskammer eingeleitet. Reste des stickstoffhaltigen Gases werden mit Hilfe der Pumpe 10 vollständig aus der Prozesskammer 15 abgesaugt.

In einem nächsten Verfahrensschritt 56 wird nach dem Spülen ein silanhaltiges Prozessgas, z.B. Dichlorsilan, über die Zuleitung 18 eingeleitet, wobei wiederum kein weiteres Prozessgas in der Prozesskammer 15 enthalten ist. Das Dichlorsilan reagiert mit Stickstoff, der sich an der Oberfläche des Substrates 12 im Verfahrensschritt 52 angelagert hat zu einer einlagigen Schicht aus Siliziumnitrid. Das silanhaltige Prozessgas wird nicht angeregt. Bei einem anderen Ausführungsbeispiel wird das silanhaltige Prozessgas schwach angeregt.

Nach dem Verfahrensschritt 56 wird in einem Verfahrensschritt 58 wieder gespült. Dabei wird so vorgegangen, wie oben für den Verfahrensschritt 54 erläutert.

Ist das Dichlorsilan vollständig aus der Reaktionskammer 15 abgesaugt, so wird in einem Verfahrensschritt 60 geprüft, ob die vorgegebene Zyklenanzahl erreicht sind. Im Ausführungsbeispiel sollen 30 Zyklen durchlaufen werden, wobei sich eine Schichtdicke von bspw. drei Nanometern ergibt. Sollen weitere Zyklen ausgeführt werden, so folgt nach dem Verfahrensschritt 60 unmittelbar der Verfahrensschritt 52. Das Verfahren befindet sich nun in einer Schleife aus den Verfahrensschritten 52 bis 60, bei deren Durchlaufen abwechselnd Stickstoff und Dichlorsilan in die Prozesskammer 15 eingeleitet werden, so dass mehrere Lagen Siliziumnitrid auf dem Substrat 12 gebildet werden.

Die Schleife aus den Verfahrensschritten 52 bis 60 wird im Verfahrensschritt 60 erst dann verlassen, wenn die vorgegebene Zyklenanzahl erreicht worden ist. Ist die vorgegebene Zyklenanzahl erreicht, so folgt unmittelbar nach dem Verfahrensschritt 60 ein Verfahrensschritt 62, in dem das Verfahren zum Erzeugen des Dielektrikums beendet wird. Optional werden weitere Schichten eines Dielektrikumstapel aus voneinander verschiedenen Schichten mit anderen Verfahren oder mit anderen Prozessparametern erzeugt.

Durch das an Hand der Figur 2 erläuterte Verfahren lässt sich eine mehrlagige Siliziumnitridschicht in guter Qualität bei Temperaturen im Bereich von 200 bis 500 Grad Celsius abscheiden.

Im folgenden wird das RPE-ALCVD AlN Verfahren erläutert, das bis auf die folgenden Unterschiede wie das RPE-ALCVD Si₃N₄ Verfahren durchgeführt wird:
- an Stelle des silanhaltigen Prozessgases wird im Verfahrensschritt 56 ein Aluminiumhaltiges Prozessgas über die Zuleitung 18 eingeleitet, z.B. Trimethylaluminium.

Es lässt sich eine mehrlagige Aluminiumnitridschicht in guter Qualität herstellen, d.h. mit geringer Defektdichte und hoher Barrierewirkung.

Bei anderen Ausführungsbeispielen wird anschließend mindestens eine weitere Dielektrikumschicht eines Dielektrikumstapels erzeugt, wobei jedoch ein herkömmliches Verfahren verwendet wird. Sehr gute Ergebnis wurden mit einem Schichtstapel erreicht, der in der angegebenen Reihenfolge eine RPE-CVD Si₃N₄- Schicht, eine ALD-Schicht (Atomic Layer Deposition) aus Al₂O₃ und eine RPE-CVD Si₃N₄- Schicht enthält.

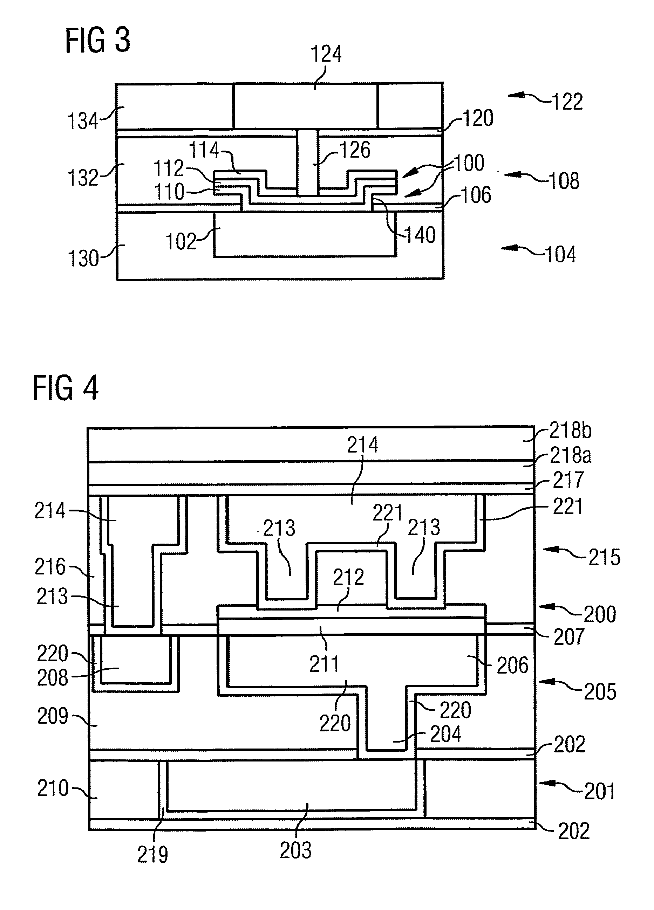

Figur 3 zeigt eine Kondensatoranordnung 100, die mit zwei zusätzlichen Maskenschritten erzeugt worden ist. Die Kondensatoranordnung 100 enthält eine Bodenelektrode 102 aus Kupfer bzw. aus einer Kupferlegierung mit einem Legierungsanteil anderer Stoffe als Kupfer von weniger als fünf Prozent. Die Bodenelektrode 102 ist in einer ebenen Metallisierungslage 104 enthalten. Die Metallisierungslage 104 wird durch eine Diffusions-Barrierenschicht 106 abgeschlossen, die mit einem üblichen Verfahren abgeschieden worden ist. Obwohl in Figur 3 nicht dargestellt, ist die Bodenelektrode 102 allseitig von einer Barriereschicht umgeben.

Die Kondensatoranordnung enthält außerdem in einer substratferneren Metallisierungslage 108 mit zunehmendem Abstand vom Substrat:
- eine elektrisch isolierende Dielektrikumschicht 110 aus Siliziumnitrid Si₃N₄ oder aus Aluminiumnitrid AlN, bzw. aus einem Schichtstapel,
- eine elektrisch leitfähige Deckelektrode 112, bspw. aus Titannitrit TiN, Tantalnitrid TaN o.ä.,
- eine Siliziumnitridschicht Si₃N₄.

Die Metallisierungslage 108 wird durch eine elektrisch isolierende Barriereschicht 120 abgeschlossen. Eine über der Metallisierungslage 108 angeordnete Metallisierungslage 122 enthält eine Leitbahn 124, z.B. ein Kupferleitbahn. Von der Leitbahn 124 führt ein Via 126 zur Deckelektrode 112. Die Metallisierungslagen 104, 108 und 122 enthalten jeweils ein Intralagendielektrikum 130, 132 bzw. 134 zur elektrischen Isolierung von Leitbahnen innerhalb einer Metallisierungslage 104, 108 und 122. Bspw. wird Siliziumdioxid oder ein low-k-Dielektrikum als Material für das Intralagendielektrikum 130, 132 bzw. 134 verwendet.

Bis zum Aufbringen der Barriereschicht 106 wird wie bisher üblich vorgegangen. Anschließend wird jedoch eine erste Teilschicht des Intralagendielektrikums 132 aufgebracht, z.B. in einer Schichtdicke, die kleiner als ein Drittel der endgültigen Dicke des Intralagendielektrikums 132 ist. In einem ersten zusätzlichen fotolithografischen Schritt wird die Lage einer Aussparung 140 festgelegt, in der der Kondensator 100 erzeugt werden soll. Die Aussparung 140 wird nach dem Belichten und Entwickeln eines Resists geätzt, bspw. mit eine RIE-Verfahren (Reaktiv Ion Etching). Die Aussparung 140 durchdringt nach dem Ätzen die erste Teilschicht des Intralagendielektrikum 132 und die Barriereschicht 106, so dass der Boden der Aussparung 140 auf der Bodenelektrode 102 liegt. Die Bodenelektrode 102 ragt allseitig über den Boden der Aussparung 140 hinaus.

Anschließend wird die Dielektrikumschicht 110 mit einem der an Hand der Figuren 1 und 2 erläuterten Verfahren ganzflächig abgeschieden. Gegebenenfalls werden danach weitere Teilschichten der Dielektrikumschicht 110 aus anderen Materialien oder mit anderen Verfahren erzeugt.

Danach wird die Deckelektrodenschicht 112 ganzflächig abgeschieden. Optional folgt die ganzflächig Abscheidung der Siliziumnitridschicht 114. Die Abscheidung der Schichten 110 bis 114 ist konform.

Danach wird ein zweiter zusätzlicher fotolithografischer Schritt zum Festlegen der Lage des Randes der Deckelektrode 112 durchgeführt. Nach dem Belichten und Entwickeln eines Resists wird geätzt, wobei auf der unteren Teilschicht des Intralagendielektrikums 132 gestoppt wird. Im Ausführungsbeispiel liegt der Rand der Deckelektrode 112 vollständig außerhalb der Aussparung 140 und hat einen Umriss, der dem Umriss der Bodenelektrode 102 entspricht.

Anschließend wird die noch fehlende Teilschicht des Intralagendielektrikum 132 abgeschieden. Nach einem optionalen Planarisierungsschritt wird dann gemäß bekannter Verfahrenschritte weiter prozessiert, wobei u.a. auch das Via 126 erzeugt wird.

Figur 4 zeigt eine Kondensatoranordnung 200, die mit nur einem zusätzlichen Maskenschritt erzeugt worden ist, in einem Querschnitt. Ein Substrat mit einer Vielzahl von Halbleiterbauelementen, z.B. von Transistoren, liegt unterhalb der dargestellten Anordnung. Eine untere, vorzugsweise ebene, Metallisierungslage 201 enthält zwischen nichtleitenden Diffusionsbarrieren 202 Leiterbahnen zum lateralen Stromtransport, z.B. eine Leiterbahn 203. Über ein Via 204 zum vertikalen Stromtransport ist die Leiterbahn 203 mit einer in einer zweiten Metallisierungslage 205 angeordneten unteren Elektrode 206 der Kondensatoranordnung 200 verbunden. Im Ausführungsbeispiel befindet sich in der Metallisierungsebene 205 links neben der Elektrode 206 eine Leitbahn 208. Die untere Elektrode 206 und die Leitbahn 208 sind in ein Zwischendielektrikum 209 eingebettet, um sie gegeneinander zu isolieren, bspw. in Siliziumdioxid. Ein Zwischendielektrikum 210 isoliert dagegen die Leitbahnen 203 der unteren Metallisierungslage 203 voneinander.

Auf der unteren Elektrode 206 ist ein Kondensatordielektrikum 211 angeordnet, bspw. ein einlagiges oder ein mehrlagiges Dielektrikum. Auf dem Kondensatordielektrikum 211 ist eine obere Elektrode 212 angeordnet. Das Kondensatordielektrikum 211 hat im Bereich der oberen Elektrode 212 eine Dicke, die größer ist als die Dicke einer Barriereschicht 207, die in der gleichen Ebene wie das Kondensatordielektrikum 211 angeordnet ist.

Die obere Elektrode 212 und die Leitbahn 208 sind über Vias 213 mit Leitbahnen 214 in einer dritten Metallisierungslage 215 elektrisch leitfähig verbunden, die ein Zwischendielektrikum 216 enthält. Oberhalb der Metallisierungslage 215 befinden eine nichtleitende Diffusionsbarriere 217 und weitere Passivierungsschichten 218a und 218b.

Die Leitbahnen 203, 208, und 214, die untere Elektrode 206 und die Vias 204, 213 sind aus einer Kupferlegierung oder aus reinem Kupfer gefertigt, bspw. mit Hilfe eines dualen-Damaszen-Verfahrens. Dabei werden in die mit Kupfer zu füllenden Gräben bzw. Löchern zuvor bspw. leitende Barriereschichten 219, 220 bzw. 221 aus Titannitrid eingebracht.

Die Diffusionsbarrieren 202, 207, 217, das Kondensatordielektrikum 211 und die Passivierungsschicht 218b bestehen im Ausführungsbeispiel aus Siliziumnitrid Si₃N₄. Die Passivierungsschicht 218a besteht im Ausführungsbeispiel aus Siliziumdioxid.

Abweichungen vom bekannten dualen Damaszen-Verfahren ergeben sich bei der Herstellung des Kondensators 200. Nach dem Planarisieren der Metallisierungslage 205, bspw. mit einem chemisch mechanischen Polierverfahren, wird ganzflächig Siliziumnitrid für das Kondensatordielektrikum 211 und für die Diffusionsbarriere 207 abgeschieden. Dabei wird ein Verfahren verwendet, wie es oben an Hand der Figuren 1 und 2 erläutert worden ist. Bei einem alternativen Ausführungsbeispiel wird an Stelle des Siliziumnitrids Aluminiumnitrid als Material für die Barriereschicht 207 und das Kondensatordielektrikum 211 verwendet und nach dem oben an Hand der Figur 2 erläuterten Verfahren aufgebracht.

Nach dem Abscheiden des Materials für die Barriereschicht 207 bzw. für das Kondensatordielektrikum 211 wird ganzflächig eine metallische Schicht zur Ausbildung der Elektrode 212 abgeschieden, bspw. eine Titannitridschicht. Alternativ wird die Elektrode 212 als Schichtstapel ausgebildet. Anschließend wir ein zusätzlicher fotolithografischer Schritt zum festlegen des Randes der Elektrode 212 durchgeführt. Nach dem Belichten und Entwickeln eines Resists wird geätzt, wobei auf der Barriereschicht 207 mit leichter Überätzung gestoppt wird. Die weitere Prozessierung erfolgt wieder nach dem bekannten dualen Damaszen-Verfahren.

Bei einem alternativen Ausführungsbeispiel wird auf die Elektrode noch eine Siliziumnitridschicht aufgebracht, die u.a. bei der Ätzung der Vias 213 als Ätzstopp dient. An Stelle von mehren Vias zum Anschluss einer Elektrode 206 bzw. 212 wird bei einem anderen Ausführungsbeispiel nur ein Via verwendet. Auch die untere Elektrode 206 lässt sich mit mehreren Vias bzw. auch von "oben" her anschließen, d.h. von einer dem Halbleitersubstrat abgewandten Seite.

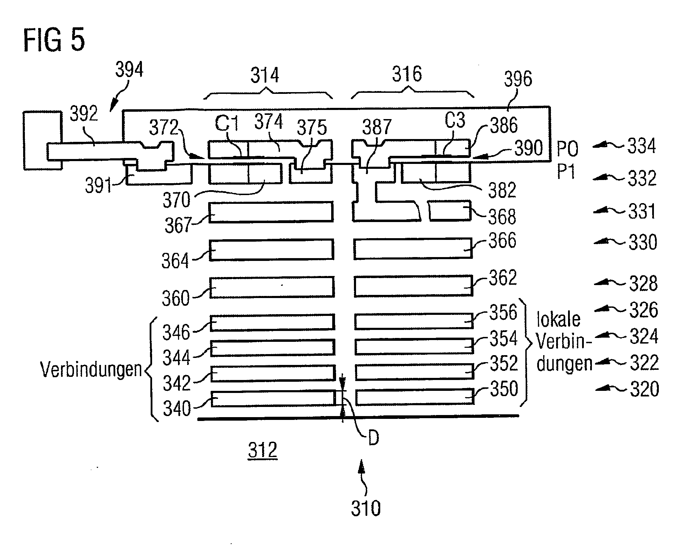

Figur 5 zeigt Kondensatoranordnungen, die keinen zusätzlichen Maskenschritt benötigen. Eine integrierte Schaltungsanordnung 310 enthält in einem Siliziumsubstrat 312 eine Vielzahl integrierter Halbleiter-Bauelemente, die jedoch in Figur 5 nicht dargestellt sind. Die im Siliziumsubstrat 312 angeordneten Bauelemente bilden zwei räumlich getrennte Bereiche, nämlich einen Analogteil 314 und einen Digitalteil 316. Im Analogteil 314 werden hauptsächlich analoge Signale bearbeitet, d.h. Signale, die einen kontinuierlichen Wertebereich haben. Im Digitalteil 316 werden dagegen hauptsächlich digitale Signale bearbeitet, d.h. Signale, die beispielsweise nur zwei Werte haben, die zwei Schaltzuständen zugeordnet sind.

Die Schaltungsanordnung 310 enthält oberhalb des Siliziumsubstrates 312 außerdem mindestens vier Metallisierungslagen, im Ausführungsbeispiel neun Metalllagen 320 bis 334, zwischen denen keine weiteren Metalllagen sondern Isolierschichten angeordnet sind. Die Metalllagen 320 bis 334 sind jeweils in einer Ebene angeordnet. Die Ebenen der Metalllagen 320 bis 334 sind parallel zueinander und auch parallel zur Hauptfläche des Siliziumsubstrats 312 angeordnet. Die Metalllagen 320 bis 334 erstrecken sich jeweils sowohl im Analogteil 314 als auch im Digitalteil 316.

Die untersten vier Metalllagen 320, 322, 324 und 326 enthalten im Analogteil 314 in der genannten Reihenfolge Verbindungsabschnitte 340, 342, 344 bzw. 346, welche Verbindungen zwischen den Bauelementen des Analogteils 314 bilden. In Figur 5 sind eine Vielzahl von Leiterbahnen als Blöcke angedeutet. Selbstverständlich gibt es auch zwischen diesen Blöcken Leitbahnen für die Verbindung von Analogteil 314 und Digitalteil 316. Im Digitalteil 316 enthalten die Metalllagen 320, 322, 324 bzw. 326 in dieser Reihenfolge Verbindungsabschnitte 350, 352, 354 bzw. 356, die lokale Verbindungen zwischen den Bauelementen des Digitalteils 316 bilden. Die Verbindungsabschnitte 340 bis 356 haben senkrecht zum Substrat 312 eine Dicke D von beispielsweise 100 nm.

Die Metalllage 328 enthält im Analogteil 314 Verbindungsabschnitte 360, die Analogsignale führen und die Bauelemente des Analogteils 314 verbinden. Im Digitalteil 316 enthält die Metalllage 328 Verbindungsabschnitte 362, welche die Bauelemente des Digitalteils 316 verbinden und damit digitale Signale führen. Ebenso enthält die Metalllage 330 im Analogteil 314 Verbindungsabschnitte 364 für Analogsignale und im Digitalteil 316 Verbindungsabschnitte 366 für Digitalsignale.

Die Metalllage 331 enthält im Analogteil 314 einen Verbindungsabschnitt 367, der den Analogteil 314 ganzflächig bedeckt und zur Abschirmung des Analogteils 314 vor darüber liegenden Bauelementen dient. Im Digitalteil 316 enthält die Metalllage 331 dagegen Verbindungsabschnitte 368, die bspw. eine Betriebsspannung oder Massepotential führen. Die Verbindungsabschnitte 360 bis 368 haben die zweifache Dicke D.

Die Metalllagen 332 und 334 bilden die beiden obersten Metalllagen. Im Analogteil 314 enthält die Metalllage 332 eine Boden-Elektrode 370 eines Kondensator 372 mit linearer Übertragungsfunktion und einer Kapazität C1. Der Kondensator C1 dient der Bearbeitung von Analogsignalen, z.B. in einem Analog-/Digitalwandler. Eine Deck-Elektrode 374 des Kondensators 372 liegt in der Metalllage 334 oberhalb der Elektrode 370. Die Deckelektrode 374 ist mit einem Verbindungsabschnitt 375 in der Metalllage 332 verbunden.

Im Digitalteil 316 enthält die Metalllage 332 einen Verbindungsabschnitte 382, der ein Betriebspotential P1 von beispielsweise 2,5 Volt führt. Oberhalb des Verbindungsabschnittes 382 liegt ein Verbindungsabschnitt 386, der ein Massepotential P0 von 0 Volt führt. Zwischen den Verbindungsabschnitten 382 und 386 wird eine Kapazität C3 gebildet, die zu einem Blockkondensator gehört. Der Verbindungsabschnitt 386 ist über einen Verbindungsabschnitt 387 in der Metalllage 332 und Vias mit einem Verbindungsabschnitt 368 in der Metalllage 331 verbunden.

Zumindest die Metalllage 332 enthält kupferhaltiges elektrisch leitfähiges Material, so dass insbesondere die Boden-Elektrode 370 des Kondensators 372 und der Verbindungsabschnitt 382 kupferhaltig sind. Optional sind auch weitere Metalllagen 320 bis 334 kupferhaltig.

Die Größe der Kapazitäten C1 und C3 wird einerseits durch die Größe der sich überlappenden Elektroden 370 und 374 bzw. der überlappenden Verbindungsabschnitte 370 bis 386 bestimmt. Andererseits wird die flächenbezogene Kapazität zwischen den Verbindungsabschnitten 370 und 374 bzw. 382 und 386 durch die Ausbildung einer Zwischenlage 390 bestimmt, welche zwischen den Metalllagen 332 und 334 liegt. Die Zwischenlage 390 ist so ausgebildet, dass sich eine flächenbezogene Kapazität von bspw. größer 0,5 fF/µm² ergibt.

Die Verbindungsabschnitte 370 bis 386 haben die vierfache Dicke D und sind damit insbesondere zum Leiten hoher Ströme geeignet, wie sie in Verbindungsabschnitten 382 und 386 zum Zuführen der Betriebsspannung auftreten.

Die Kapazität C3 wird aus elektrisch leitenden Abschnitten zweier Metallisierungslagen 332 und 334 gebildet, die beispielsweise keine Signale führen sondern ausschließlich zum Führen der Betriebsspannung verwendet werden. Insofern Signale geführt werden, werden die Signalleitung mit gleichen Verlauf in beiden Metallisierungslagen ausgelegt.

Bei dem in Figur 5 gezeigten Fall sind das im Fall des sogenannten "PAD-LIN-CAP"-Konzepts die obere Kupfer-Metallisierungslage und darauf eine Aluminium-Metallisierungslage, die mindestens 90 Volumenprozent Aluminium enthält. Die Aluminium-Metallisierungslage wird auch zum Bonden verwendet, siehe ein Bondpad 392 in der Metalllage 334 und eine Bondöffnung 394 in einer Passivierung 396. Das Bondpad 392 ist mit einem Verbindungsabschnitt 391 in der Metalllage 334 verbunden.

Das Dielektrikum 390 zwischen den beiden Metallisierungslagen 332 und 334 ist ein Dielektrikum oder ein Dielektrikumstapel, der gemäß einem der oben erläuterten Verfahren hergestellt worden ist. Im mixed-signal-Teil 314 des Chips ergeben sich lineare Kondensatoren C1, deren Kapazität durch die Größe der Kupferplatte 370 bestimmt ist. An Leitungsüberkreuzungen im Digitalteil 316 ergeben sich ebenfalls Kondensatoren C3, die aber nicht parasitär sind und auch nicht stören, weil sie zur Stabilisierung der Versorgungsspannung beitragen. Da im mixed-signal-Teil 314 der Schaltung 310 des Chips in der Regel weniger Metallisierungslagen benötigt werden als im Digitalteil 316, kommt dieses Konzept ohne zusätzliche Maskenschritte aus.

Es ist ebenfalls möglich, das oben beschriebene Dielektrikum 390 bzw. den oben beschriebenen Dielektrikumstapel für das sogenannte "POWER-LIN-CAP"-Konzept zu verwenden. Dabei befindet sich das Dielektrikum 390 bzw. der Dielektrikumstapel zwischen den beiden letzten Kupfer-Metallisierungslagen. Die Aluminium-Metallisierungslage wird dann nicht mehr benötigt. Das Bonden erfolgt dann direkt auf Kupfer.

Zusammenfassend gilt, das insbesondere Hochfrequenzschaltungen in BIPOLAR-, BICMOS- (BIpolar Complementary Metal Oxide Semiconductor) und CMOS-Technologie (Complementary Metal Oxide Semiconductor) Kondensatoren mit hoher Flächenkapazität, z.B. höher als 0,7 fF/µm², und mit niedrigen parasitären Kapazitäten benötigen. Die bisher eingesetzten konventionellen MOS- bzw. MIS-Kondensatoren zeigen als nachteilige Eigenschaften eine starke Spannungsabhängigkeit auf Grund spannungsinduzierter Raumladungszonen und hohe parasitäre Kapazitäten infolge des geringen Abstandes zum Substrat. Diese Probleme lassen sich durch den Einsatz von MIM-Kondensatoren (Metall Isolator Metall) umgehen, die möglichst ohne Veränderung und Beeinflussung der benachbarten Metallbahnen in die Metallisierung integriert werden sollen, insbesondere in eine mehrlagige Metallisierung. Auch sollen für das Einfügen der MIM-Kondensatoren möglichst wenige zusätzliche Verfahrensschritte erforderlich sein, insbesondere zusätzliche fotolithografische Schritte.

Um einen möglichst defektfreien Kondensator mit hoher Lebensdauer zu erhalten, ist die Wahl geeigneter Dielektrika-Grenzflächen von entscheidender Bedeutung. Insbesondere bei Kupfermetallisierungen führt das Aufbringen von gebräuchlichen Dielektrika ohne zusätzlich Maßnahmen zu nicht mehr akzeptablen Defektdichten bzw. zu einer verminderten Zuverlässigkeit. Für diese Defektdichten sind hauptsächlich Verunreinigungen des Dielektrikums durch Kupferdiffusion oder Nebenphasen sowie Kupferhillocks verantwortlich, welche zu Singularitäten in der Feldverteilung bzw. zu Feldspitzen führen. Diese Verunreinigungen und Kupferhillocks werden durch die erläuterten Verfahren zum Aufbringen des Dielektrikums verringert oder verhindert.

## Patentansprüche

1. Verfahren zum Ausbilden eines Dielektrikums (110) auf einer Metallisierung (102),
mit den Schritten:
Erzeugen einer Metallisierung (102) auf einem Substrat, wobei die Metallisierung (102) als einen Metallisierungsbestandteil Kupfer enthält,
Heranführen mindestens zweier Prozessgase (26, 28),
Ausbilden des Dielektrikums (110) angrenzend an die Metallisierung (102),
wobei das Dielektrikum (110) mindestens zwei Arten von Bestandteilen enthält, die aus voneinander verschiedenen Prozessgasen (26, 28) stammen,
wobei das Dielektrikum (110) das Dielektrikum (110) eines Kondensators (100) ist,
und wobei die Flächenkapazität des Kondensators höher als 0,7 fF/µm² ist,
**dadurch gekennzeichnet, dass** die beiden Prozessgase (26, 28) mit voneinander verschiedener Plasmaleistung je Substratfläche angeregt werden oder dass das eine Prozessgas (26) mit einem Plasma angeregt wird und das andere Prozessgas (28) nicht angeregt wird,
wobei das stärker angeregte Prozessgas (26) getrennt von dem weniger stark oder nicht angeregten Prozessgas (28) in einer von einer Reaktionskammer (15) getrennten Kammer (13) angeregt wird.

2. Verfahren nach einem der vorhergehenden Ansprüche, **dadurch gekennzeichnet, dass** die Prozessgase als Prozessgasgemisch herangeführt werden,
oder dass das Dielektrikum (110) mit Hilfe eines Abscheideverfahrens erzeugt wird, bei dem die Prozessgase (26, 28) voneinander getrennt an die Metallisierung (102) herangeführt werden, vorzugsweise zyklisch, insbesondere in mindestens zehn Zyklen.

3. Verfahren nach einem der vorhergehenden Ansprüche, **gekennzeichnet durch** mindestens einen der folgenden Schritte:
Ausbilden des Dielektrikums (110) aus einem Material, das eine Diffusionsbarriere für Kupfer ist,
Ausbilden des Dielektrikums (110) aus einem Material, das der Elektromigration von Kupfer entgegenwirkt,
Ausbilden des Dielektrikums (110) aus Siliziumnitrid, insbesondere aus Si₃N₄, oder aus einem Material, das Siliziumnitrid enthält,
Heranführen eines siliziumhaltigen Prozessgases (28), insbesondere von Silan, Disilan, Dichlorsilan, Trichlorsilan,
Bis(tertbutylamino)silan oder einem Gasgemisch aus mindestens zwei dieser Gase,
Heranführen eines stickstoffhaltigen Gases (26), insbesondere von Stickstoff, Ammoniakgas oder einem Gemisch dieser Gase.

4. Verfahren nach einem der Ansprüche 1 oder 2, **gekennzeichnet durch** mindestens einen der folgenden Schritte:
Ausbilden des Dielektrikums (110) aus einem Material, das eine Diffusionsbarriere für Kupfer ist,
Ausbilden des Dielektrikums (110) aus einem Material, das der Elektromigration von Kupfer entgegenwirkt,
Ausbilden des Dielektrikums (110) aus Aluminiumnitrid, oder aus einem Material, das Aluminiumnitrid enthält,
Heranführen eines aluminiumhaltigen Prozessgases, insbesondere von Trimethylaluminium,
Heranführen eines stickstoffhaltigen Gases, insbesondere von Stickstoff, Ammoniakgas oder einem Gemisch dieser Gase.

5. Verfahren nach einem der vorhergehenden Ansprüche, **dadurch gekennzeichnet, dass** der Metallisierungsanteil mindestens fünf Volumenprozent oder mindestens vierzig Volumenprozent oder mindestens neunzig Volumenprozent der Metallisierung beträgt.

6. Verfahren nach einem der vorhergehenden Ansprüche, **dadurch gekennzeichnet, dass** das Dielektrikum (110) das Dielektrikum (110) eines Kondensators (100) mit zwei metallischen Elektroden (102, 112) ist, zwischen denen das Dielektrikum (110) angeordnet ist.

7. Verfahren nach Anspruch 6, **dadurch gekennzeichnet, dass** das gesamte Dielektrikum (110) des Kondensators (100) mit einem Verfahren nach einem der Ansprüche 1 bis 5 hergestellt wird.

8. Verfahren nach einem der Ansprüche 1 bis 6, **gekennzeichnet durch** die Schritte:
Ausbilden einer Dielektrikumschicht (110) mit einem Verfahren nach einem der Ansprüche 1 bis 6,
anschließend Ausbilden mindestens einer weiteren dielektrischen Schicht angrenzend an die Dielektrikumschicht, wobei die weitere Schicht eine andere Materialzusammensetzung hat und/oder mit einem anderen Verfahren und/oder mit anderen Prozessparametern erzeugt wird als die Dielektrikumschicht (110),
vorzugsweise Ausbilden der weiteren Schicht **durch** eine Oxidation, insbesondere eine anodische Oxidation.

9. Verfahren nach Anspruch 8, **gekennzeichnet durch** den Schritt:
Ausbilden einer dielektrischen Schicht mit einem Verfahren nach einem der Ansprüche 1 bis 6 nach dem Ausbilden der weiteren Schicht, insbesondere angrenzend an die weitere Schicht.

10. Verfahren nach Anspruch 8 oder 9, **dadurch gekennzeichnet, dass** die weitere Schicht eine relative Dielektrizitätskonstante größer sieben hat, und insbesondere ein Oxid enthält, vorzugsweise Aluminiumoxid, Tantaloxid oder Hafniumoxid enthält.

## Claims

1. A process for forming a dielectric (110) on a metallization (102),
comprising the steps of:
producing a metallization (102) on a substrate, the metallization (102) containing copper as a metallization constituent,
supplying at least two process gases (26, 28),
forming the dielectric (110) adjacent to the metallization (102),
the dielectric (110) containing at least two types of constituents which originate from different process gases (26, 28),
the dielectric (110) is the dielectric (110) of a capacitor (100),
the capacitance per unit area of the capacitor is higher than 0.7 fF/µm²,
**characterized in that** the two process gases (26, 28) being excited with different plasma powers per unit substrate area, or **in that** one process gas (26) being excited with a plasma and the other process gas (28) not being excited,
whereby the more strongly excited process gas (26) is excited separately from the less strongly excited or unexcited process gas (28) in a chamber (13) that is separate from a reaction chamber (15).

2. The process as claimed in one of the preceding claims, **characterized in that** the process gases are supplied as a process gas mixture,
or **in that** the dielectric (110) is produced with the aid of a deposition process in which the process gases (26, 28) are supplied to the metallization (102) separately from one another, preferably cyclically, in particular in at least 10 cycles.

3. The method as claimed in one of the preceding claims, **characterized by** at least one of the following steps:
forming the dielectric (110) from a material which is a diffusion barrier to copper,
forming the dielectric (110) from a material which counteracts the electromigration of copper,
forming the dielectric (110) from silicon nitride, in particular from Si₃N₄, or from a material which contains silicon nitride,
supplying a silicon-containing process gas (28), in particular silane, disilane, dichlorosilane, trichlorosilane, bis(tertbutylamino)silane or a gas mixture comprising at least two of these gases,
supplying a nitrogen-containing gas (26), in particular nitrogen, ammonia gas or a mixture of these gases.

4. The process as claimed in one of claims 1 or 2, **characterized by** at least one of the following steps:
forming the dielectric (110) from a material which is a diffusion barrier to copper,
forming the dielectric (110) from a material which counteracts the electromigration of copper,
forming the dielectric (110) from aluminum nitride or from a material which contains aluminum nitride,
supplying an aluminum-containing process gas, in particular trimethyl aluminum,
supplying a nitrogen-containing gas, in particular nitrogen, ammonia gas or a mixture of these gases.

5. The process as claimed in one of the preceding claims, **characterized in that** the metallization fraction amounts to at least five percent by volume or at least forty percent by volume or at least ninety percent by volume of the metallization.

6. The process as claimed in one of the preceding claims, **characterized in that** the dielectric (110) is the dielectric (110) of a capacitor (100) with two metallic electrodes (102, 112), between which the dielectric (110) is arranged.

7. The process as claimed in claim 6, **characterized in that** the entire dielectric (110) of the capacitor (100) is produced by the process as claimed in one of claims 1 to 5.

8. The process as claimed in one of claims 1 to 6, **characterized by** the steps of:
forming a dielectric layer (110) by the process as claimed in one of claims 1 to 6,
then forming at least one further dielectric layer adjacent to the dielectric layer, the further layer having a different material composition and/or being produced by a different process and/or using different process parameters than the dielectric layer (110),
preferably forming the further layer by oxidation, in particular anodic oxidation.

9. The process as claimed in claim 8, **characterized by** the step of:
forming a dielectric layer by the process as claimed in one of claims 1 to 10 after the further layer has been formed, in particular adjacent to the further layer.

10. The process as claimed in claim 8 or 9, **characterized in that** the further layer has a relative dielectric constant of greater than seven and in particular contains an oxide, preferably contains aluminum oxide, tantalum oxide or hafnium oxide.

## Revendications

1. Procédé de formation d'un diélectrique (110) sur une métallisation (102),
comprenant les stades :
on produit une métallisation (102) sur un substrat, la métallisation (102) contenant du cuivre comme un constituant de métallisation,
on fait arriver au moins deux gaz (26, 28) de processus,
on forme le diélectrique (110) au voisinage de la métallisation (102),
le diélectrique (110) contenant au moins deux types de constituant qui proviennent de gaz (26, 28) de processus différents l'un de l'autre,
dans lequel le diélectrique (110) est le diélectrique (110) d'un condensateur,
et dans lequel la capacité par unité de surface du condensateur est plus grande que 0,7 Ff/µm²,
**caractérisé en ce que** l'on excite les deux gaz (26, 28) de processus par des puissances de plasma différentes l'une de l'autre par surface de substrat ou **en ce que** l'on excite l'un des gaz (26) de processus par un plasma et on n'excite pas l'autre gaz (28) de processus,
dans lequel on excite le gaz (26) de processus excité le plus séparément du gaz (28) de processus qui est moins excité ou qui n'est pas excité dans une chambre (13) séparée d'une chambre (15) de réaction.

2. Procédé suivant l'une des revendications précédentes, **caractérisé en ce que** l'on fait arriver les gaz de processus sous la forme d'un mélange de gaz de processus,
ou **en ce que** l'on produit le diélectrique (110) à l'aide d'un procédé de dépôt dans lequel on fait arriver les gaz (26, 28) de processus séparément l'un de l'autre sur la métallisation (102), de préférence cycliquement, notamment dans au moins dix cycles.

3. Procédé suivant l'une des revendications précédentes, **caractérisé par** au moins l'un des stades suivants :
on forme le diélectrique (10) en un matériau qui est une barrière de diffusion pour du cuivre,
on forme le diélectrique (110) en un matériau qui s'oppose à l'électromigration du cuivre,
on forme le diélectrique (110) en nitrure de silicium, notamment en Si₃N₄, ou en un matériau qui contient du nitrure de silicium,
on fait arriver un gaz (28) de processus contenant du silicium notamment du silane, du disilane, du dichlorosilane, du trichlorosilane, du bis(terbutylamino)silane ou un mélange gazeux d'au moins deux de ces gaz,
on fait arriver un gaz (26) azoté, notamment de l'azote, de l'ammoniac gazeux ou un mélange de ces gaz.

4. Procédé suivant l'une des revendications 1 ou 2, **caractérisé par** au moins l'un des stades suivants :
on forme le diélectrique (10) en un matériau qui est une barrière de diffusion pour du cuivre,
on forme le diélectrique (110) en un matériau qui s'oppose à l'électromigration du cuivre,
on forme le diélectrique (110) en nitrure d'aluminium ou en un matériau qui contient du nitrure d'aluminium,
on fait arriver un gaz de processus contenant de l'aluminium notamment de l'aluminium triméthyle,
on fait arriver un gaz azoté, notamment de l'azote, de l'ammoniac gazeux ou un mélange de ces gaz.

5. Procédé suivant l'une des revendications précédentes, **caractérisé en ce que** la proportion de métallisation représente au moins 5% en volume ou au moins 40% en volume ou au moins 90% en volume de la métallisation.

6. Procédé suivant l'une des revendications précédentes, **caractérisé en ce que** le diélectrique (110) est le diélectrique (110) d'un condensateur (100) ayant deux électrodes (102, 112) métalliques entre lesquelles est disposé le diélectrique (110)

7. Procédé suivant la revendication 6, **caractérisé en ce que** l'on produit tout le diélectrique (110) du condensateur (100) par un procédé suivant l'une des revendications 1 à 5.

8. Procédé suivant l'une des revendications 1 à 6, **caractérisé par** les stades :
on forme une couche (110) de diélectrique par un procédé suivant l'une des revendications 1 à 6,
on forme ensuite au moins une autre couche diélectrique voisine de la couche de diélectrique, l'autre couche ayant une composition de matière autre et/ou étant produite par un procédé autre et/ou par des paramètres de processus autres que la couche (110) de diélectrique,
on forme de préférence l'autre couche par une oxydation, notamment par une oxydation anodique.

9. Procédé suivant la revendication 8, **caractérisé par** le stade :
on forme une couche diélectrique par un procédé suivant l'une des revendications 1 à 6 après la formation de l'autre couche, notamment au voisinage de l'autre couche.

10. Procédé suivant la revendication 8 ou 9, **caractérisé en ce que** l'autre couche a une constante diélectrique relative sept fois plus grande et contient notamment un oxyde, de préférence de l'oxyde d'aluminium, de l'oxyde de tantale ou de l'oxyde d'hafnium.
